# EUROPEAN PATENT SPECIFICATION

(11) **EP 0 803 896 B1**
(45) Date of publication and mention of the grant of the patent: **07.01.2004**
(21) Application number: 97302744.4
(22) Date of filing: 22.04.1997
(51) Int. Cl.: H01J 37/32

(54) **Plasma processing system and protective member used for the same**
Plasmabehandlungsvorrichtung und Schutzteil dafür
Dispositif de traitement par plasma et élément de protection utilisé dans un tel dispositif

(30) Priority: 22.04.1996 JP 12407596
(43) Date of publication of application: 29.10.1997
(73) Proprietor: NISSHINBO INDUSTRIES INC., Chuo-ku, Tokyo (JP)
(72) Inventor: Saito, Kazuo, c/o Tokyo Research Center, Adachi-ku, Tokyo (JP); Mochizuki, Yasushi, c/o Tokyo Research Center, Adachi-ku, Tokyo (JP)
(74) Representative: Stuart, Ian Alexander

(56) References cited:
- EP-A- 0 673 056
- EP-A- 0 763 504
- PATENT ABSTRACTS OF JAPAN vol. 008, no. 063 (E-233), 24 March 1984 & JP 58 213427 A (HITACHI SEISAKUSHO KK), 12 December 1983,
- PATENT ABSTRACTS OF JAPAN vol. 017, no. 205 (C-1051), 22 April 1993 & JP 04 349197 A (SHIMADZU CORP), 3 December 1992,

## Description

The present invention relates to a plasma etching system, e.g. as used for production of semiconductor integrated circuits, such as LSIs or ICs, or waveguides for optical communication, and to a protective member used in the system.

In recent years, a plasma processing technique, such as a plasma etching technique or a plasma CVD technique, capable of forming a finer pattern on a wafer at a high accuracy has come to be increasingly important along with the advance of techniques for producing semiconductor integrated circuits with finer geometries and higher densities.

An electrode used for such a plasma processing technique has been made of aluminium, graphite, glassy carbon, metal silicon or quartz.

On the other hand, parts of a plasma processing system, such-as a chamber or a member called "depo-shield" (protective member), have been generally made of aluminium, and in recent years, to meet requirements for high integration of semiconductors, these parts made of aluminium have come to be further subjected to surface treatment by anodic oxidation.

In processing a wafer by plasma etching, the adhesion of dust on the surface of the wafer is undesirable. Such dust has been considered to result from scattering of particles of electrodes when the electrodes are eroded and consumed by plasma, and attempts have been made to suppress the generation of dust from electrodes. However, as a result of various investigations made by the present inventors, it has been found that such dust is caused not only by electrodes but also by the plasma processing system itself.

Specifically, although a chamber or a protective member of a plasma processing system is made of aluminium as described, it is possibly brought in direct contact with plasma and also exposed to a corrosive gas and thereby damaged. Such damage of the chamber or protective member causes the generation of dust in addition to shortened service life. Therefore, it would be desirable to develop a protective member capable of suppressing the damage thereof for preventing the generation of dust.

JP58-213427 discloses a plasma etching system including electrode covers of silica glass which cover the discharge region. JP04-3491197 discloses apparatus for forming thin films, with surfaces coated with glassy carbon so that carbon films deposited thereon will adhere strongly.

Preferred embodiments of the present invention may provide a plasma etching system and a protective member used for the system, which are capable of suppressing the generation of particles (dust) and prolonging service life.

According to a first aspect of the present invention, there is provided a protective member for a plasma etching system, which is disposed in use in a plasma processing chamber containing two plasma generating electrodes for forming a plasma region between the electrodes, outside of the two electrodes in such a manner as to cover the plasma region, characterized in that the protective member is formed of a glassy carbon material.

According to a second aspect of the present invention, there is provided a plasma etching system including a plasma processing chamber in which plasma generating electrodes of glassy carbon or metal silicon are disposed, together with at least one protective member according to the first aspect disposed at the side of the two electrodes.

The plasma etching system of the present invention is advantageous in that since a protective member is formed of a glassy carbon material, it is suppressed from being eroded or damaged by plasma, as a result of which it is possible to prolong the service life thereof and also to suppress the generation of particles (dust) and hence to prevent the adhesion of dust on a workpiece such as a wafer upon plasma etching.

The present invention disclosed herein will be understood better with reference to the following drawing of which:

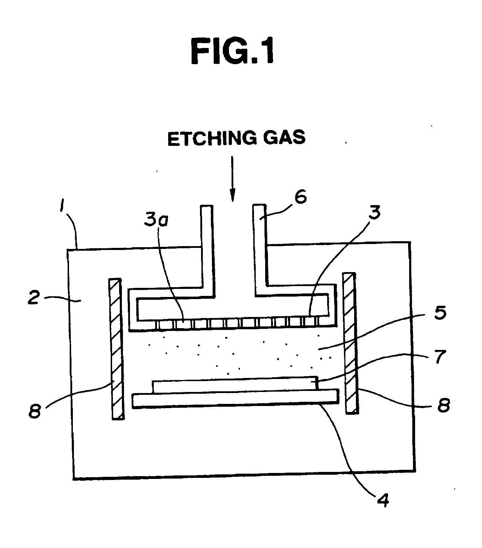

Fig. 1 is a schematic view showing one embodiment of the present invention.

An embodiment of the present invention will be described with reference to the accompanying drawing.

Fig. 1 shows a plasma etching system to which the present invention is applied. A main body 1 of the processing system contains a plasma processing chamber 2. In this plasma processing chamber 2, two plasma generating electrodes 3, 4 confront each other at a specified distance, so that a plasma region 5 is formed between them. An etching gas feed pipe 6 is connected to one electrode (upper electrode) 3. An etching gas passes through the feed pipe 6, and is fed into the plasma region 5 from a plurality of etching gas communication holes 3a formed in the upper electrode 3. A workpiece 7, for example a silicon wafer, is placed on the other electrode (lower electrode) 4. In addition, while not shown, the upper electrode 3 is connected to a high frequency power supply and the lower electrode 4 is grounded.

Protective members 8, 8 are disposed at respective sides outside both the electrodes 3, 4 in such a manner as to cover the plasma region 5.

In accordance with the present invention, each protective member 8, 8 is formed of a glassy carbon material.

Specific examples of source materials of the above glassy carbon material include cellulose, furfuryl alcohol, phenol resin, acetone, polycarbodiimide resin, furan resin, furfural resin, other thermosetting resins, and mixtures thereof.

The electrodes are formed of a glassy carbon or metal silicon. The main body of the system may be formed of a known material such as aluminium. Of course, the inner wall surface of the main body of the system may be entirely covered with a glassy carbon material, or a surface portion of the main body of the system which is possibly exposed to plasma leaked from gaps between both the electrodes and the protective members may be covered with a glassy carbon material.

The plasma etching system shown in Fig. 1 is usable for a long period of time in accordance with the normal processing manner while significantly suppressing the generation of particles (dust) because the protective members, formed of the glassy carbon material, are prevented from being eroded or damaged by plasma.

### EXAMPLES

The present invention will be more clearly understood with reference to the following examples:

### Example 1

A protective member sample having a shape as shown in Fig. 1 was prepared using a glassy carbon material (density: 1.51 g/cm³, total ash: 2 ppm) produced from phenol resin.

### Example 2

A protective member having a shape as shown in Fig. 1 was prepared using a glassy carbon material (density: 1.52 g/cm³, total ash: 10 ppm) produced from furan resin.

### Comparative Example 1

A protective member which was formed of aluminium, followed by anodising treatment, was used as a protective member sample.

### Comparative Example 2

A protective member sample having a shape as shown in Fig. 1 was prepared using an isotropic graphite (density: 1.85 g/cm³).

Next, each of the above protective member samples was set into the plasma etching system shown in Fig. 1 in the manner shown in Fig. 1, and an oxide film on a silicon wafer (diameter: 8 inch (20cm)) was etched by plasma using a mixed gas of trifluoromethane as a reaction gas, argon and oxygen. After this etching, the number of particles (particle size: 0.3 µm or more) adhering on the surface of the wafer was counted. The results are shown in Table 1. In this experiment, a plasma generating electrode formed of a glassy carbon material was used as the electrode, and the main body of the system was formed of aluminium.

From the results shown in Table 1, it is revealed that the protective member samples of Examples 1 and 2 were significantly small in the number of particles (dust) adhering on the surface of the wafer even at the 1500-th processing, as compared with the protective member samples in Comparative Examples 1 and 2.

**Table 1**

| | material | construction | number of particles (dust) on wafer at the 10-th processing | number of particles (dust) on wafer at the 1500-th processing |
|---|---|---|---|---|
| Example 1 | glassy carbon | single body | 4 | 4 |
| Example 2 | glassy carbon | single body | 3 | 5 |
| Comparative Example 1 | aluminium, alumite treated | single body | 10 | 250 |
| Comparative Example 2 | isotropic graphite | single body | 140 | 300 |

## Claims

1. A protective member (8) for a plasma etching system, which is disposed in use in a plasma processing chamber (2) containing two plasma generating electrodes (3,4) for forming a plasma region between said electrodes, outside of said two electrodes in such a manner as to cover said plasma region, **characterised in that** said protective member is formed of a glassy carbon material.

2. A plasma etching system comprising a plasma processing chamber (2) containing two plasma generating electrodes for forming a plasma region between said electrodes, and at least one protective member (8), **characterised in that** said at least one protective member (8) is as defined in claim 1 and is disposed at the side of said two electrodes in such a manner as to cover said plasma region; and **in that** said electrodes (3,4) are formed of a glassy carbon or metal silicon.

3. A plasma etching system according to claim 2 having a pair of said protective members (8) disposed at respective sides of said electrodes (3,4).

4. A plasma processing system according to claim 2 or claim 3 wherein at least a surface of an internal portion, exposed to plasma, of said plasma processing chamber (2) excluding said electrodes is formed of a glassy carbon material.

5. Use of a system according to claims 2, 3 or 4 for plasma etching.

## Patentansprüche

1. Schutzelement (8) für ein Plasmaätzsystem, das bei der Verwendung in einer Plasmabearbeitungskammer (2), die zwei Plasmaerzeugungselektroden (3, 4) enthält, um eine Plasmazone zwischen den Elektroden zu bilden, außerhalb der beiden Elektroden auf solche Weise angeordnet ist, dass es die Plasmazone bedeckt, **dadurch gekennzeichnet, dass** das Schutzelement aus einem glasartigen Kohlenstoffmaterial gebildet ist.

2. Plasmaätzsystem, das eine Plasmabearbeitungskammer (2), die zwei Plasmaerzeugungselektroden enthält, um eine Plasmazone zwischen den Elektroden zu bilden, und zumindest ein Schutzelement (8) umfasst, **dadurch gekennzeichnet, dass** das zumindest eine Schutzelement (8) wie in Anspruch 1 definiert ist und auf der Seite der beiden Elektroden auf solche Weise angeordnet ist, dass es die Plasmazone bedeckt; und dass die Elektroden (3, 4) aus einem glasartigen Kohlenstoff oder Metallsilizium gebildet sind.

3. Plasmaätzsystem nach Anspruch 2, bei dem ein Paar der Schutzelemente (8) auf jeweiligen Seiten der Elektroden (3, 4) angeordnet ist.

4. Plasmaätzsytem nach Anspruch 2 oder 3, worin zumindest eine Plasma ausgesetzte Oberfläche eines inneren Abschnitts der Plasmabearbeitungskammer (2) mit Ausnahme der Elektroden aus einem glasartigen Kohlenstoffmaterial gebildet ist.

5. Verwendung eines Systems nach einem der Ansprüche 2, 3 oder 4 zum Plasma-ätzen.

## Revendications

1. Elément formant protection (8) pour un système de gravure par plasma, lequel est disposé pour une utilisation dans une enceinte de traitement par plasma (2) contenant deux électrodes de production de plasma (3, 4) pour former une région de plasma entre lesdites électrodes, à l'extérieur desdites deux électrodes, de telle manière qu'il couvre ladite région de plasma, **caractérisé en ce que** ledit élément formant protection est constitué d'un matériau de carbone vitreux.

2. Système de gravure par plasma comprenant une enceinte de traitement par plasma (2) contenant deux électrodes de production de plasma pour former une région de plasma entre lesdites électrodes, et au moins un élément formant protection (8), **caractérisé en ce que** ledit au moins un élément formant protection (8) est tel que défini dans la revendication 1, et est disposé sur le côté desdites deux électrodes de telle manière qu'il couvre ladite région de plasma, et **en ce que** lesdites électrodes (3, 4) sont constituées de carbone vitreux ou de silicium métallique.

3. Système de gravure par plasma selon la revendication 2 ayant une paire desdits éléments formant protection (8) disposés sur les côtés respectifs desdites électrodes (3, 4).

4. Système de traitement par plasma selon la revendication 2 ou la revendication 3, dans lequel au moins une surface d'une partie interne exposée au plasma de ladite enceinte de traitement par plasma (2), à l'exception desdites électrodes, est constituée d'un matériau de carbone vitreux.

5. Utilisation d'un système selon les revendications 2, 3 ou 4 pour la gravure par plasma.
